(19) Europäisches Patentamt

European Patent Office

Office européen des brevets

(11) **EP 1 929 628 B1**

(12) **EUROPÄISCHE PATENTSCHRIFT**

(45) Veröffentlichungstag und Bekanntmachung des Hinweises auf die Patenterteilung:
**28.12.2016 Patentblatt 2016/52**

(21) Anmeldenummer: **06806852.7**

(22) Anmeldetag: **27.09.2006**

(51) Int Cl.:
***H03K 3/57*** *(2006.01)*

(86) Internationale Anmeldenummer:
**PCT/EP2006/066805**

(87) Internationale Veröffentlichungsnummer:
**WO 2007/036542 (05.04.2007 Gazette 2007/14)**

(54) **VERFAHREN ZUR ERZEUGUNG INTENSIVER HOCHSPANNUNGSIMPULSE FÜR DEN INDUSTRIELLEN EINSATZ UND ZUGEHÖRIGE SCHALTUNGSANORDNUNG**

METHOD FOR GENERATING INTENSE HIGH-VOLTAGE PULSES FOR INDUSTRIAL USE AND CORRESPONDING CIRCUIT ARRANGEMENT

PROCEDE DE PRODUCTION D'IMPULSIONS DE HAUTE TENSION INTENSES POUR L'UTILISATION INDUSTRIELLE ET ENSEMBLE CIRCUIT ASSOCIE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **28.09.2005 DE 102005046411**

(43) Veröffentlichungstag der Anmeldung:
**11.06.2008 Patentblatt 2008/24**

(73) Patentinhaber: **Südzucker Aktiengesellschaft Mannheim/Ochsenfurt**
**97199 Ochsenfurt (DE)**

(72) Erfinder: **HARTMANN, Werner**
**91085 Weisendorf (DE)**

(74) Vertreter: **Gleiss & Grosse**
**Patentanwälte Rechtsanwälte**
**Leitzstrasse 45**
**70469 Stuttgart (DE)**

(56) Entgegenhaltungen:
**WO-A-2004/100371**

**Beschreibung**

Die Erfindung bezieht sich auf ein Verfahren zur Erzeugung intensiver Höchspannungsimpulse und für den industriellen Einsatz dieser Hochspannungsimpulse. Daneben bezieht sich die Erfindung auch auf die zugehörige Schaltungsanordnung zur Durchführung des Verfahrens.

Für zahlreiche industrielle Verfahren werden intensive Hochspannungsimpulse eingesetzt. Beispielsweise werden

- im Bauwesen Baustoffe durch einen elektrohydraulischen Stoffaufschluss, wie z. B. Beton oder Asphalt, für die Qualitätsanalyse zugänglich gemacht oder es werden
- Baustoffe wie z. B. armierter Stahlbeton, durch stoßwellenbasierte, d.h. elektrohydraulische Verfahren recycelt.

Andere Einsatzmöglichkeiten intensiver Hochspannungspulse im Rahmen industrieller Anwendungen sind beispielsweise

- in der Biotechnologie, bei der Zellproteine, DNA oder andere Zellinhalts- oder Zellwandbestandteile aus biologischen Zellen durch Elektroporation der Zellwände extrahiert werden, oder
- in der Umwelttechnologie, bei der z. B. Klärschlamm durch Elektroporation vorbehandelt wird, um so Fäulnisprozesse besser zu kontrollieren.

Weitere mögliche Einsatzfelder für Hochspannungspulse ergeben sich bei der Behandlung bzw. Sterilisation landwirtschaftlicher Produkte, insbesondere zur Beseitigung von tierischen und pilzlichen Schäden durch Zerstörung des Zellverbandes aufgrund der hohen elektrischen Felder auf der Außenhaut der landwirtschaftlichen Produkte, wenn diese in einen Bereich ausreichend hoher elektrischer Feldstärke (Reaktor) gebracht werden.

Obige Anwendungen beim Einsatz von Hochspannungspulsen werden teilweise in Veröffentlichungen von Schultheiss et al. "INDUSTRIAL-SCALE ELECTROPORATION OF PLANT MATERIAL USING HIGH REPETITION RATE MARX GENERATORS", Proceedings IEEE Pulsed Power Conference, 2002 und "OPERATION OF 20 HZ MARX GENERATORS ON A COMMON ELECTROLYTIC LOAD IN AN ELECTROPORATION CHAMBER", Proceedings IEEE Power Modulator Symposium, 2003, angesprochen.

Für solche Anwendungen werden typischerweise Impulsamplituden von einigen 100 kV bei Stromstärken von einigen 10 kA bei Impulsraten von einigen 10 Pulsen pro Sekunde (pps) im Dauerbetrieb benötigt. Bei industriell eingesetzten Verfahren ist für die Wirtschaftlichkeit solcher Anlagen eine wartungsfreie Anlagenlebensdauer von einigen 100 Mio. Impulsen unabdingbar.

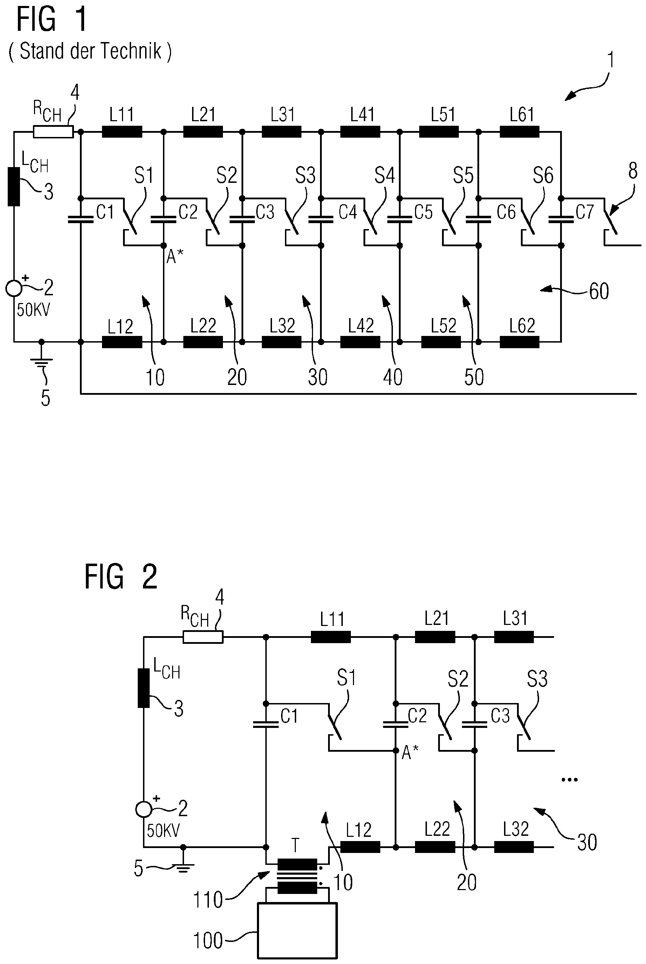

Zur Herstellung der notwendigen hohen Feldstärken werden - dem Stand der Technik entsprechend - Hochspannungs-Impulsgeneratoren nach dem Marx-Prinzip eingesetzt, bei dem Kondensatoren parallel aufgeladen, zur Pulserzeugung.jedoch durch geeignete Schalter in Serie geschalten werden, was in Figur 1 als Stand der Technik dargestellt ist und weiter unten im Einzelnen beschrieben wird.

Hauptproblem bei der Impulserzeugung sind die dabei benötigten Schalter, meist gasgefüllte Funkenstrecken, und deren gezielte Auslösung mit hoher Genauigkeit über die gesamte Lebensdauer.

Bei einer bekannten Lösung des Problems werden für die Schalter Funkenstrecken eingesetzt, welche so ausgelegt sind, dass sie eine Lebensdauer von über 100 Mio. Impulsen erreichen sollen. Zwar existieren erste Problemlösungen für Marxgeneratoren mit elektronischen Schaltelementen entsprechend der Veröffentlichung von Kirbie et al. "All-Solid-State Marx Modulator with Digital Pulse-Shape Synthesis", Bericht Nr. LA-UR-05-0631, Los Alamos National Laboratory, Los Alamos, NM, USA 2005.

Letztere Problemlösungen erreichen aber noch keine ausreichend hohen Ströme für den industriellen Einsatz.

Die bisher für Marxgeneratoren eingesetzten Gasentladungsschalter werden gemäß der Veröffentlichung von Schultheiss et al. "Wear-less Trigger Method for Marx Generators in Repetitive Operation", Proceedings IEEE Power Modulator Symposium, 2003 im repetierenden Betrieb meist ungetriggert eingesetzt dergestalt, dass der Abstand der Funkenstreckenelektroden der ersten Marx-Generatorstufe einen etwas geringeren Abstand aufweisen als die der anderen Stufen; dadurch ist die Durchbruchspannung dieser Funkenstrecken etwas geringer als die der folgenden und die erste Stufe zündet als erste durch. Dadurch wird an der zweiten Funkenstrecke eine Überspannung von knapp 100% der Ladespannung erzeugt, wodurch die zweite Stufe ebenfalls durchzündet. Analog zünden darauf auch die folgenden Stufen durch, bis der gesamte Marx-Generator aufgerichtet ist und einen entsprechenden Impuls am Ausgang erzeugt.

Um einen größeren Gesamtstrom und damit eine höhere Gesamtleistung zu erzielen, ist es oftmals notwendig, mehrere solcher Anlagen parallel zu betreiben. Dazu ist es jedoch insbesondere notwendig, den Zeitpunkt der Impulserzeugung der einzelnen Marx-Generatoren mit hoher Genauigkeit zeitlich zu synchronisieren. Diese Synchronisation ist auch für eine Einzelanlage notwendig, wenn eine gute Kontrolle der Betriebsparameter für den gewünschten Prozess erforderlich ist. Eine Synchronisation erfolgt i. A. dadurch, dass die Zündung der Funkenstrecke der ersten Stufe nicht durch Überschreiten der Zündspannung während des Aufladevorganges erfolgt, sondern diese Funkenstrecke gezielt gezündet wird. Für diese Zündung stehen mehrere Möglichkeiten zur Verfügung:

- Plasmaquertriggerung (Trigatron)
- Plasmalängstriggerung
- Überspannungslängstriggerung
- Lasertriggerung

Sowohl die Plasmaquertriggerung als auch die Plasmalängstriggerung weisen bisher keine ausreichend langen Lebensdauern auf. Die Lasertriggerung erfordert einen sehr hohen apparativen Aufwand und Kosten bei begrenzter Lebensdauer der Funkenstrecke und wird daher meist nur für Einzelimpulsbetrieb bei sehr großen Forschungsanlagen eingesetzt.

Die Überspannungslängstriggerung ist die am Besten geeignete Methode. Allerdings existiert bisher keine praxisgerechte Einrichtung mit ausreichend guten Eigenschaften und ausreichender Lebensdauer. Aus der WO 2004/100371 A1 sind bereits Trigger-/Zündeinrichtung in einem aus Stufenkondensatoren bestehendem Marx-Generator und ein zugehöriges Betriebsverfahren für diese Einrichtung bekannt. Bei dem dort angewandten Verfahren zur Erzeugung von Hochspannungsimpulsen wird der Marx-Generator wird mit Hochspannungsimpulsen getriggert, wobei die Triggerimpulse seriell-induktiv eingekoppelt werden.

Die vorbeschriebene Lösung liefert in der Praxis weder eine ausreichend hohe Triggerqualität noch eine ausreichende Lebensdauer. Sie beruht darauf, in die erdseitige Ladeinduktivität der ersten Marxstufe induktiv einen Spannungsimpuls einzukoppeln (Impulstransformator), der in einer Hilfswicklung (Primärwicklung) durch das elektronische Unterbrechen eines Stromes mit Hilfe von Halbleiterschaltern erzeugt wird. Dabei muss die zur Überspannungserzeugung und Zündung der Funkenstrecke notwendige Energie in der primärseitigen Wicklung des Impulstransformators zwischengespeichert werden, was zu sehr ungünstigen Auslegungskriterien dieser Anordnung führt. Weiterhin ist das öffnende elektronische Schaltelement meist ein IGBT im Moment der Impulserzeugung im geöffneten Zustand, wodurch es sehr empfindlich gegenüber Rückwirkungen aus dem Marx-Generator ist, insbesondere gegenüber Überspannungen.

Letzteres führt im Allgemeinen dazu, dass eine solche Schaltung eine begrenzte, für den industriellen Einsatz nicht ausreichende Lebensdauer aufweist. Weiterhin ist die Skalierbarkeit dieses Prinzips extrem schwierig, da starke Kompromisse bezüglich widersprechender Anforderungen gemacht werden müssen. Beispielsweise erfordert die Bereitstellung ausreichend hoher Impulsenergien zur sicheren Zündung der Funkenstrecke eine hohe Eigeninduktivität der Primärwicklung, während die Anforderung an eine hohe Steilheit des so erzeugten Impulses eine möglichst niedrige Induktivität erfordert.

Aufgabe der Erfindung ist es daher, ein Verfahren zur Triggerung eines Marx-Generators anzugeben und einen geeigneten Marx-Generator zu schaffen, bei denen der Wirkungsgrad erhöht wird, so dass neue industrielle Anwendungen möglich sind. Insbesondere soll ein triggerbarer Marx-Generator mit einer Vorrichtung zur Erzeugung und Einkopplung von Hochspannungsimpulsen in die erste Stufe des Marx-Generators geschaffen werden, welche zu einer sicheren Überspannungslängstriggerung der ersten Funkenstrecke des Marx-Generators mit geringer statistischer Schwankung des Zündzeitpunktes ("Jitter") führt bei einer Lebensdauer der Anordnung von über 200 Mio. Impulsen.

Die Aufgabe ist erfindungsgemäß durch ein Verfahren gemäß Anspruch 1 gelöst. Eine geeignete Anordnung mit einem Marx-Generator ist Gegenstand des Patentanspruches 8. Weiterbildungen des erfindungsgemäßen Verfahrens, insbesondere auch damit nunmehr mögliche Verwendungen, und der zugehörigen Einrichtung sind Gegenstand der Unteransprüche.

Die Erfindung benutzt einen bekannten Marx-Generator, bei dem eine seriell-kapazitive Einkopplung des Triggerimpulses erfolgt. Dies bewirkt überraschenderweise einen verbesserten Wirkungsgrad gegenüber der bei der WO 2004/10.0371 A1 realisierten induktiven Einkopplung. Insbesondere wird damit der sonst störende "Jitter" besser als beim Stand der Technik beseitigt.

Bei der Erfindung wird erfindungsgemäß in die masseseitige Zuleitung der erdseitigen Ladeinduktivität der ersten Stufe eines Marx-Generators die Sekundärseite eines Impulstransformators T eingefügt, welcher auf seiner Primärseite mit einer Schaltung zur Impulserzeugung verbunden ist. Der Transformator T hat bei der Erfindung ein Übersetzungsverhältnis Ü (sekundärseitige/primärseitige Windungszahl) im Bereich 8:1 bis 20:1, vorzugsweise im Bereich 15:1. Primärseitig werden vorteilhafterweise nur wenige Windungen eingesetzt, vorzugsweise nur eine oder zwei Windungen, um die Induktivität der Anordnung gering zu halten und damit Impulse mit ausreichend kurzer Dauer zu erzeugen.

Die Ladeinduktivität kann im Bereich von 100 $\mu$H bis 2 mH dimensioniert werden, ohne die Funktionsfähigkeit der Schaltung negativ zu beeinflussen. Es kann die gleiche Ladeinduktivität wie für alle anderen Stufen verwendet werden.

Für den Impulstransformator T wird vorzugsweise ein Ferritringkern oder ein amorpher, ringförmiger Schnittbandkern mit Kernabmessungen im Bereich von einigen $cm^2$ Querschnitt eingesetzt. Die Wicklungen können sowohl mit hochspannungsisoliertem Kabel direkt auf dem Kern aufgebracht werden als auch auf einem isolierendem Wickelkörper oder separaten Wickelkörpern; auch das direkte Aufbringen der Primärwicklung auf dem Kern und das Aufbringen der Sekundärwicklung auf einem isolierendem Wickelkörper ist möglich. Die Anordnung kann sowohl in isolierender Gasatmosphäre als auch in isolierender Flüssigkeit (Öl, Silikonöl, etc.) isoliert werden. Auch ein Verguss mit geeigneten Harzen oder anderen Polymeren ist möglich.

Die primärseitige Schaltung zur Erzeugung des Hochspannungsimpulses wird vorzugsweise so ausgeführt, dass ein auf eine vorgegebene Spannung aufgeladener Kondensator $C_p$ mit Hilfe eines schließenden Halbleiterschalters in die Primärwicklung des Impulstransformators entladen wird. Die Kapazität des Kondensators $C_p$ wird mindestens so groß gewählt, dass die Beziehung

$$C_p = \ddot{U}^2 * C_s \qquad\qquad (1)$$

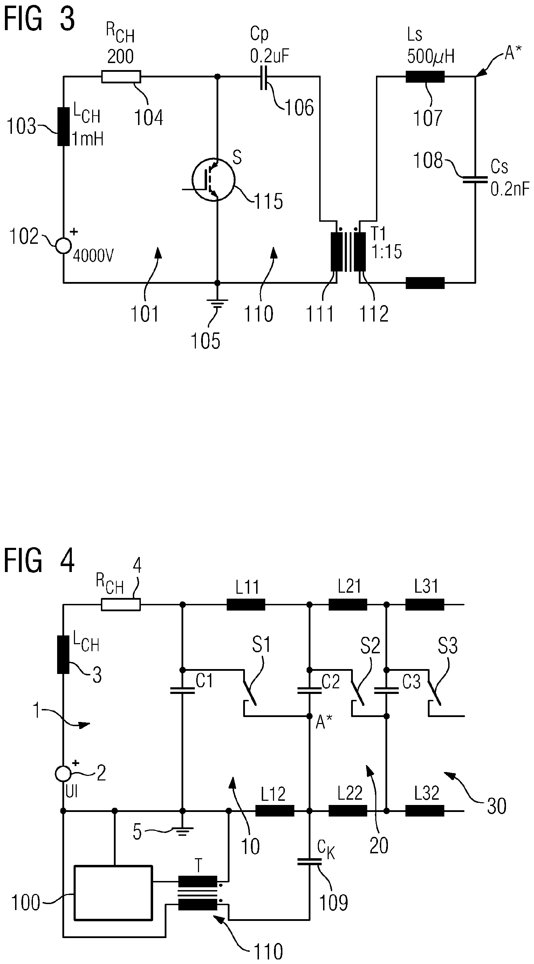

erfüllt wird, wobei $C_s$ die gesamte Streukapazität des Knotens A* in Abbildung 3, d.h. am erdnahen Ende der Funkenstrecke der ersten Stufe des Marx-Generators, ist. Vorzugsweise wird die Kapazität etwa 3- bis 4-mal so groß gewählt, um ausreichende Energiereserven für die Auslösung eines Zündfunkens in der Funkenstrecke FS1 bereitzustellen. Typische Streukapazitäten liegen im Bereich von einigen 100 pF, typischerweise ca. 200 pF, so dass bei einem Übersetzungsverhältnis von Ü = 15 eine primärseitige Kapazität von mindestens

$$C_p = \ddot{U}^2 * C_s = 225 * 200 \text{ pF} = 45 \text{ nF} \qquad\qquad (2)$$

gefordert wird, besser jedoch $C_p$ = 150...200 nF.

Die Ladespannung des Kondensators wird mindestens so groß gewählt, dass die Beziehung

$$U_{Cp} = U_L / \ddot{U} \qquad\qquad (3)$$

erfüllt wird; dadurch wird eine Längsüberspannung von ca. 100 % der Marxladespannung $U_L$ an der Funkenstrecke FS1 erzeugt, so dass diese mit kurzer Verzugszeit (Delay) und geringem Jitter zündet. Bei einer Stufenspannung $U_L$ des Marx-Generators von 60 kV wird somit eine Ladespannung für $C_p$ von

$$U_{Cp} = U_L / \ddot{U} = 60 \text{ kV} / 15 = 4 \text{ kV} \qquad\qquad (4)$$

benötigt.

Zwischenkreisspannungen von ca. 4 kV bei Impulsströmen von typ. 500 A Amplitude können mit verfügbaren Leistungshalbleitern als Schaltelement S problemlos verarbeitet werden. Geeignet sind z. B. Thyristor-Bauelemente wie GTOs oder IGCTs sowie Transistorschalter wie IGBTs mit Sperrspannungen oberhalb von 5 kV.

Bei der erfindungsgemäßen Anordnung wird vorteilhafterweise ein schließender Halbschalter verwendet. Dies ist deshalb besonders vorteilhaft, da durch den Einsatz kommerzieller Halbleiterbauelemente eine hohe Lebensdauer und eine geringe Empfindlichkeit gegen Rückwirkung aus dem Marx-Generator deswegen gegeben ist, weil das Halbleiterschaltelement während des Hauptpulses im geschlossenen Zustand verbleibt. Die Verwendung der in den höheren Marxstufen eingesetzten Ladeinduktivität ist auch in der ersten Stufe möglich, und es ist durch die erdseitige Auslegung der Impulserzeugung der Einsatz einer geerdeten Stromversorgung beliebiger Leistung möglich.

In einer erfindungsgemäß bevorzugten Anordnung wird der zur Funkenstreckenzündung notwendige Hochspannungsimpuls nicht induktiv in Serie mit der Ladeinduktivität eingekoppelt, sondern mit einer seriellen Kapazität $C_K$ zur Entkopplung gegen Gleichstrom- und langsame Wechselstromanteile. Um den Spannungsverlust durch kapazitive Spannungsteilung an $C_K$ gering zu halten, sollte die Bedingung

$$C_K >> C_s, \text{ mindestens jedoch } C_K = (5 \dots 10) * C_s \qquad (5)$$

erfüllt werden.

Bei der Erfindung ergibt sich somit eine ausgezeichnete Skalierbarkeit mit allen notwendigen Freiheitsgraden, wobei keine Einschränkungen für den Betrieb in Hinsicht auf Impulsamplitude, Impulsenergie, oder Impulswiederholrate sowie Lebensdauer vorliegen.

Weitere Einzelheiten und Vorteile der Erfindung ergeben sich aus nachfolgender Figurenbeschreibung von Ausführungsbeispielen anhand der Zeichnung in Verbindung mit den Patentansprüchen. Es zeigen

Figur 1     ein Prinzipschaltbild eines Marx-Generators gemäß dem Stand der Technik,

Figur 2     ein Ersatzschaltbild eines Marx-Generators mit einer induktiv-seriellen Einkopplung des Triggerimpulses in der ersten Stufe,

Figur 3     ein Ersatzschaltbild der Schaltung zur Erzeugung von Hochspannungsimpulsen für die Triggerung des Marx-Generators nach Figur 2 und

Figur 4     ein Ersatzschaltbild eines Marx-Generators mit kapazitiver Einkopplung des Triggerimpulses in der ersten Stufe.

In der Figur 1 ist die prinzipielle Schaltung eines bekannten Marx-Generators dargestellt, der insgesamt mit 1 bezeichnet ist. Der Marx-Generator 1 besteht im Einzelnen aus einer Spannungsquelle 2, beispielsweise einer Quelle mit einer Gleichspannung von 50 kV, der eine Induktivität 3 und ein ohmscher Widerstand 4 vorgeschaltet sind. Weiterhin ist eine Erdung 5 vorhanden.

In bekannter Weise besitzt ein derartiger Marx-Generator 1 eine Anzahl von einzelnen Stufen, beispielsweise sechs Stufen entsprechend Figur 1. Jede Stufe i beinhaltet einen Schalter $S_i$, eine erste Induktivität $L_{ik}$, einer weiteren Induktivität $L_{ik+1}$ und einer Kapazität $C_i$, wobei i und k laufende Indices darstellen. In anderen Ausführungsformen können statt der Induktivitäten $L_{ik}$ Widerstände oder Hochspannungsgleichrichter eingesetzt werden. Im Folgenden wird jedoch nur von Induktivitäten $L_{ik}$ gesprochen. Beispielsweise hat die dritte Stufe des Marx-Generators einen Schalter $S_3$ mit Funkenstrecke, einen Kondensator $C_3$, eine erste Induktivität $L_{31}$ und eine zweite Induktivität $L_{32}$.

In der Figur 1 ist eine direkte Triggerung der einzelnen Funkenstrecken entsprechend den Pfeilen angedeutet. Diese Art der Triggerung kann aber nur bei geringen Lebensdauern der Schalter und im Allgemeinen auch nicht in allen Stufen eingesetzt werden.

In Figur 2 ist der ersten Stufe 10 des Marx-Generators gemäß Figur 1 ein Triggerimpulsgenerator 100 zugeordnet. Der Triggerimpulsgenerator 100 koppelt über einen Transformator 110 einen Triggerimpuls in die erste Stufe 10 des Marx-Generators ein. Dabei erfolgt die Einkopplung induktiv-seriell an der Induktivität $L_{12}$.

In Figur 3 ist eine verbesserte Alternative zu Figur 2 dargestellt. In diesem Fall erfolgt über den Triggerimpulsgenerator 100 und den vorgeschalteten Transformator 110 sowie über eine Koppelkapazität 109 eine kapazitive Einkopplung des Triggerimpulses auf die Induktivität $L_{12}$ der ersten Stufe 10 des Marx-Generators 1. Dies hat den Vorteil, dass der ansonsten unvermeidliche "Jitter" verringert werden kann. Der Wirkungsgrad wird somit höher.

In der Figur 3 ist ein Schalter S mit 115 bezeichnet. Der Schalter 115 ist zur bestimmungsgemäßen Anwendung als schließender Halbleiterschalter ausgebildet, beispielsweise als IGCT mit einer Sperrspannung von mindestens 5 kV. Solche Halbleiterschalter sind kommerziell erhältlich.

Durch den Einsatz kommerzieller Halbleiterbauelemente ist einerseits eine hohe Lebensdauer gewährleistet und ist andererseits eine geringe Empfindlichkeit gegen Rückwirkung aus dem Marx-Generator gegeben, da das Halbleiterschaltelement während des Hauptpulses im geschlossenen Zustand verbleibt.

Anhand Figur 4 wird verdeutlicht, wie der Triggerpuls eingekoppelt wird. Entsprechend Figur 2 oder Figur 3 ist der Transformator 110 dargestellt, der beispielsweise ein Übertragungsverhältnis 1:15 hat. Es ist eine Spannungsquelle 102 für beispielsweise 4000 V vorhanden, der eine Induktivität 103 und ein ohmscher Widerstand 104 vorgeschaltet sind. Die Induktivität 103 hat einen Wert von beispielsweise $L_{CH}$ = 1 mH und der ohmsche Widerstand 104 einen Wert von beispielsweise $R_{CH}$ = 200 $\Omega$. Es ist weiterhin eine Kapazität 106 mit einem Wert $C_P$ = 0,2 $\mu$F, eine weitere Kapazität 108 mit einem Wert von $C_s$ = 0,2 nF entsprechend der Lastkapazität an Punkt A* der ersten Stufe des Marxgenerators, und eine weitere Induktivität 107 mit einem Wert $L_s$ = 500 $\mu$H vorhanden.

Ein besonderer Vorteil der kapazitiv-parallelen Impulseinkopplung besteht darin, dass durch die Entkopplung von Gleichspannungsanteilen über die Koppelkapazität $C_K$ die Streuinduktivität des Impulstransformators T erheblich kleiner gehalten werden als die zugeordnete parallele Ladeinduktivität $L_{12}$. Somit lassen sich erheblich steilere Spannungsflanken am Punkt A* erzeugen, wodurch sich deutlich kleinere Gitterwerte erzeugen lassen. Ein weiterer Vorteil ergibt sich dadurch, dass höhere Spannungsamplituden erzielbar sind, da der induktive Spannungsabfall über $L_{12}$ bei induktiv-serieller Einkopplung entfällt.

Mit der Schaltungsanordnung gemäß Figur 4 wird über den Impulstransformator 110 ein Impuls über die Induktivität $L_{12}$ auf die Streukapazität $C_s$ gekoppelt, und zwar an den zwischen $L_{12}$ und $C_s$ liegenden Punkt A*.

Bei der anhand der Figuren 1 bis 4 beschriebenen Schaltungsanordnung wird durch den Einsatz kommerzieller Halbleiterbauelemente für den Schalter 115 eine hohe Lebensdauer gewährleistet. Es ergibt sich eine geringe Empfindlichkeit gegen die Rückwirkung aus dem Marx-Generator, da das Halbleiterschaltelement während des Hauptpulses im geschlossenen Zustand verbleibt.

Durch die Stabilität der Schaltung lässt sich für eine ununterbrochene Betriebsdauer einer Anlage von typischerweise 100 Tagen ein ständiger Einsatz der Schaltungsanordnung mit Impulswiderholraten von 10 bis 20 Hz beherrschen und es ist eine wartungsfreie Anlagenlebensdauer von über 100 Millionen Impulsen erreichbar.

Die vorstehend beschriebene Schaltungsanordnung findet Anwendung beispielsweise bei der Sterilisation landwirtschaftlicher Produkte durch starke elektrische Felder. Insbesondere können damit Getreide, Mais, Hopfen, Tomaten und Obst haltbar gemacht werden.

Möglich ist auch ein Einsatz bei der Extraktion von Zellinhaltsstoffen oder Hüllenbausteinen (Proteinen) aus Zellen in der pharmazeutischen und chemischen Industrie. Beispielsweise kann ein biologischer Aufschluss von Blut durchgeführt werden.

Weiterhin eignet sich das anhand des neuen Marx-Generators zur Generierung von Hochspannungspulsen beschriebene Verfahren zum Einsatz bei der Behandlung von Wasser und Abwasser.

Schließlich ist auch eine Anwendung bei der Analyse von Baustoffen, insbesondere von Asphalt und Beton, möglich, wobei eine elektrohydraulische Zerkleinerung und Aufschluss von Asphalt- oder Betonproben erfolgt. Daneben ist die Anwendung beim Recycling von Baustoffen wie Beton und Asphalt durch die elektrohydraulische Zerkleinerung und nachfolgenden Aufschluss möglich.

**Patentansprüche**

1. Verfahren zur Erzeugung intensiver Hochspannungsimpulse für den industriellen Einsatz, bei der ein Impulstransformator und ein Transformator verwendet werden, mit folgenden Maßnahmen:

   - Es wird ein Marx-Generator aus mehreren Stufen verwendet,
   - der Marx-Generator wird zum geeigneten Zeitpunkt mit Hochspannungsimpulsen getriggert,
   - die Erzeugung und Einkopplung der Hochspannungsimpulsen erfolgt in der ersten Stufe des Marx-Generators,
   - die Hochspannungspulse führen zu einer Überspannungslängstriggerung der ersten Funkenstrecke des Marx-Generators,
   - die Erzeugung der Hochspannungsimpulse erfolgt durch Entladung eines kapazitiven Energiespeichers (Kondensators) mithilfe eines schließenden Halbleiterschalters, **dadurch gekennzeichnet, dass**
   - zur Minimierung des Jitters die Triggerpulse parallelkapazitiv eingekoppelt werden.

2. Verfahren nach Anspruch 1, gekennzeichnet in der Anwendung bei der Sterilisation landwirtschaftlicher Produkte durch starke elektrische Felder, insbesondere zur Haltbarmachung von Getreide, Mais, Hopfen, Tomaten, und Obst.

3. Verfahren nach Anspruch 1, gekennzeichnet in der Anwendung bei der Extraktion von Zellinhaltsstoffen oder Hüllenbausteinen (Proteinen) aus Zellen in der pharmazeutischen und chemischen Industrie.

4. Verfahren nach Anspruch 3, **dadurch gekennzeichnet, dass** ein Zellaufschluss von Blut durchflossen wird.

5. Verfahren nach Anspruch 1, gekennzeichnet in der Anwendung bei der Analyse von Baustoffen, insbesondere von Asphalt und Beton, durch elektrohydraulische Zerkleinerung und Aufschluss von Asphalt- oder Betonproben.

6. Verfahren nach Anspruch 1, gekennzeichnet in der Anwendung beim Recycling von Baustoffen wie Beton und Asphalt durch deren elektrohydraulische Zerkleinerung und Aufschluss.

7. Verfahren nach Anspruch 1, gekennzeichnet in der Anwendung bei der Behandlung von Wasser und Abwasser.

8. Schaltungsanordnung zur Durchführung des Verfahrens nach Anspruch 1 oder einem der Ansprüche 2 bis 7, mit einem Marx-Generator, der eine vorgegebene Anzahl einzelner Stufen aufweist und Mitteln zur Triggerung des Marx-Generators, wobei Mittel zur Erzeugung und Einkopplung von Hochspannungsimpulsen in die erste Stufe (10) des Marx-Generators (1) vorhanden sind, die zu einer Überspannungslängstriggerung der ersten Funkenstrecke des Marx-Generators (1) führen, und wobei der Hochspannungsimpuls durch Entladung eines kapazitiven Energiespeichers in die Primärseite eines Hochspannungstransformators (110) mit einem schließenden Halbleiterschalter (115) erfolgt.

9. Anordnung nach Anspruch 8, **dadurch gekennzeichnet, dass** in die masseseitige Leitung der erdseitigen Ladeinduktivität (L) der ersten Stufe (10) des Marx-Generators (1) die Sekundärseite (112) eines Impulstransformators (110) eingefügt ist, wobei der Impulstransformator (110) auf seiner Primärseite (111) mit einer Schaltung (100) zur Impulserzeugung verbunden ist.

10. Anordnung nach Anspruch 9, **dadurch gekennzeichnet, dass** der Transformator ein Übersetzungsverhältnis im Bereich zwischen 8:1 bis 20:1, vorzugsweise im Bereich 15:1 hat.

11. Anordnung nach Anspruch 10, **dadurch gekennzeichnet, dass** der Transformator (110) primärseitig nur wenige Windungen, vorzugsweise eine oder zwei Windungen, hat.

12. Anordnung nach einem der Ansprüche 8 bis 11, **dadurch gekennzeichnet, dass** die Ladeinduktivität ($L_{ik}$) im Bereich von 100 $\mu$H bis 2 mH ist.

13. Anordnung nach Anspruch 12, **dadurch gekennzeichnet, dass** die Ladeinduktivität (L) in allen Stufen (10, ..., 60) des Marx-Generators (1) gleich ist.

14. Anordnung nach Anspruch 13, **dadurch gekennzeichnet, dass** der Impulstransformator (110) einen Ferritkern oder einen Schnittbandkern hat.

15. Anordnung nach Anspruch 14, **dadurch gekennzeichnet, dass** die Kernabmessungen des Impulstransformators (110) einen Bereich von etwa 10 cm$^2$ Querschnitt haben.

16. Anordnung nach einem der Ansprüche 8 bis 15, **dadurch gekennzeichnet, dass** beim Impulstransformator (110) die Wicklungen mit einem hochspannungsisolierten Draht auf dem Kern aufgebracht sind.

17. Anordnung nach einem der Ansprüche 8 bis 16, **dadurch gekennzeichnet, dass** beim Impulstransformator (110) die Wicklungen auf einem isolierenden Wickelkörper oder auf separaten Wickelkörpern aufgebracht sind.

18. Anordnung nach einem der Ansprüche 9 bis 17, **dadurch gekennzeichnet, dass** eine isolierende Gasatmosphäre oder eine isolierende Flüssigkeit zwecks Isolierung vorhanden ist.

19. Anordnung nach einem der Ansprüche 16 bis 18, **dadurch gekennzeichnet, dass** beim Impulstransformator (110) ein Verguss mit geeigneten Materialien, insbesondere Harzen oder anderen Polymeren, vorliegt.

20. Anordnung nach einem der Ansprüche 9 bis 19, **dadurch gekennzeichnet, dass** eine primärseitige Schaltung zur Erzeugung von Hochspannungsimpulsen vorhanden ist, die einen auf eine vorgebbare Spannung aufladbaren Kondensator (104) und einen schließenden Halbleiterschalter (105) in der Primärwicklung (111) des Impulstransformators (110) enthalten.

## Claims

1. A method for generating intensive high-voltage pulses for industrial use, in which a pulse transformer and a transformer are used, comprising the following measures:

    - a Marx generator consisting of a number of stages is used,
    - the Marx generator is triggered with high-voltage pulses at the suitable time,
    - the high-voltage pulses are generated and coupled in in the first stage of the Marx generator,
    - the high-voltage pulses lead to a longitudinal overvoltage triggering of the first spark gap of the Marx generator,
    - the high-voltage pulses are generated by discharging a capacitive energy store (capacitor) with the aid of a closing semiconductor switch, **characterized in that** the trigger pulses are coupled in by parallel capacitive coupling for minimizing the jitter.

2. The method according to claim 1, for use in the sterilization of agricultural products by means of strong electrical fields, particularly for preserving grain, corn, hops, tomatoes and fruit.

3. The method according to claim 1, for use in the extraction of cell content substances or building blocks of shells (proteins) from cells in the pharmaceutical and chemical industry.

4. The method according to claim 3, **characterized in that** blood is flown through for cell disruption.

5. The method according to claim 1, for use in the analysis of building materials, particularly of asphalt and concrete, by electrohydraulic disintegration and breakdown of asphalt or concrete samples.

6. The method according to claim 1, for use in the recycling of building materials such as concrete and asphalt by electrohydraulic disintegration and breakdown thereof.

7. The method according to claim 1, for use in the treatment of water and waste water.

8. A circuit for carrying out the method according to claim 1 or one of claims 2 to 7, comprising a Marx generator having a predetermined number of individual stages and means for triggering the Marx generator, wherein means for generating and coupling high-voltage pulses into the first stage (10) of the Marx generator (1) are present, which lead to a longitudinal overvoltage triggering of the first spark gap of the Marx generator (1), and wherein the high-voltage pulse takes place by discharging a capacitive energy store into the primary side of a high-voltage transformer (110) with a closing semiconductor switch (115).

9. The circuit according to claim 8, **characterized in that** the secondary side (112) of a pulse transformer (110) is inserted into the line at the frame of the charging inductance (L) at the ground end of the first stage (10) of the Marx generator (1), wherein the pulse transformer (110) is connected to a circuit (100) for pulse generation on its primary side (111).

10. The circuit according to claim 9, **characterized in that** the transformer has a transformation ratio within the range of between 8:1 to 20:1, preferably within the range of 15:1.

11. The circuit according to claim 10, **characterized in that** the transformer (110) only has a few turns on the primary side, preferably one or two turns.

12. The circuit according to one of claims 8 to 11, **characterized in that** the charging inductance ($L_{ik}$) is within the range from 100 $\mu$H to 2 mH.

13. The circuit according to claim 12, **characterized in that** the charging inductance (L) is equal in all stages (10, ..., 60) of the Marx generator (1).

14. The circuit according to claim 13, **characterized in that** the pulse transformer (110) has a ferrite core or a cut tape-wound core.

15. The arrangement according to claim 14, **characterized in that** the core dimensions of the pulse transformer (110) have a range of about 10 $cm^2$ cross section.

16. The arrangement according to one of claims 8 to 15, **characterized in that** the windings in the pulse transformer (110) are applied to the core with a high-voltage-insulated wire.

17. The arrangement according to one of claims 8 to 16, **characterized in that** the windings in the pulse transformer (110) are applied to an insulating coil former or to separate coil formers.

18. The arrangement according to one of claims 9 to 17, **characterized in that** there is an insulating gas atmosphere or an insulating liquid for the purpose of insulation.

19. The arrangement according to one of claims 16 to 18, **characterized in that** casting using suitable materials, particularly resins or other polymers, is provided in the pulse transformer (110).

20. The arrangement according to one of claims 9 to 19, **characterized in that** there is a circuit at the primary side for generating high-voltage pulses, which contains a capacitor (104) which can be charged up to a predeterminable voltage and a closing semiconductor switch (105) in the primary winding (111) of the pulse transformer (110).

**Revendications**

1. Procédé de production d'impulsions de haute tension intenses pour l'utilisation industrielle, dans lequel est utilisé un transformateur d'impulsions et un transformateur, avec les mesures suivantes :

    - à cet effet est utilisé un générateur de Marx constitué de plusieurs étages,

- le générateur de Marx est déclenché à des instants appropriés à l'aide d'impulsions de haute tension,
- la production et l'injection des impulsions de haute tension se produit dans le premier étage du générateur de Marx,
- les impulsions de haute tension conduisent à un déclenchement longitudinal de surtension du premier éclateur du générateur de Marx,
- la production des impulsions de haute tension s'effectue par la décharge d'un accumulateur d'énergie capacitif (condensateur) à l'aide d'un commutateur à semi-conducteurs à fermeture, **caractérisé en ce, que**
- pour minimiser le vacillement d'impulsion, les impulsions de déclenchement sont injectées à coup de capacité parallèle.

2. Procédé selon la revendication 1, caractérisé dans son application dans la stérilisation de produits agricoles par d'intenses champs électriques, en particulier pour la conservation des céréales, du maïs, du houblon, des tomates et des fruits.

3. Procédé selon la revendication 1, **caractérisé par** son application dans l'extraction de constituants cellulaires ou des éléments constitutifs de tissus (protéines) de cellules dans l'industrie pharmaceutique et chimique.

4. Procédé selon la revendication 3, **caractérisé en ce, que** du sang soit traversé afin de détruire des cellules.

5. Procédé selon la revendication 1, caractérisé dans son application dans l'analyse de matériaux de construction, en particulier pour l'asphalte et le béton, par la réduction dimensionnelle et la désintégration électro-hydrauliques d'échantillons d'asphalte ou de béton.

6. Procédé selon la revendication 1, caractérisé dans son application dans le recyclage de matériaux de construction, comme le béton et l'asphalte, par leur réduction dimensionnelle et désintégration électro-hydrauliques.

7. Procédé selon la revendication 1, **caractérisé par** son application dans le traitement de l'eau et des eaux usées.

8. Ensemble circuit pour l'exécution du procédé selon la revendication 1 ou selon l'une des revendications 2 à 7, avec un générateur de Marx comportant un nombre prédéfini d'étages individuels et des moyens pour le déclenchement du générateur de Marx, l'ensemble comportant des moyens de production et d'injection d'impulsions de haute tension dans le premier étage (10) du générateur de Marx (1) qui conduisent à un déclenchement longitudinal de surtension du premier éclateur du générateur de Marx (1) et qui sont produites par la décharge d'un accumulateur d'énergie capacitif dans le primaire d'un transformateur de haute tension (110) à l'aide d'un commutateur à semi-conducteurs (115) à fermeture.

9. Ensemble selon la revendication 8, **caractérisé en ce, que** soit intégré dans la ligne côté masse de l'inductance de charge (L) du premier étage (10) du générateur de Marx (1) le secondaire (112) d'un transformateur d'impulsions (110), le transformateur d'impulsions (110) étant raccordé sur son primaire (111) à un circuit (100) pour la production d'impulsions.

10. Ensemble selon la revendication 9, **caractérisé en ce, que** le transformateur ait un rapport de transformation situé dans une plage de 8:1 à 20:1, de préférence de niveau 15:1.

11. Ensemble selon la revendication 10, **caractérisé en ce, que** le transformateur (110) ne comporte que peu de spires côté primaire, de préférence une ou deux spires.

12. Ensemble selon l'une des revendications 8 à 11, **caractérisé en ce, que** l'inductance de charge ($L_{ik}$) soit située dans une plage de 100 $\mu$H à 2 mH.

13. Ensemble selon la revendication 12, **caractérisé en ce, que** l'inductance de charge (L) soit identique dans tous les étages (10, ..., 60) du générateur de Marx (1).

14. Ensemble selon la revendication 13, **caractérisé en ce, que** le transformateur d'impulsions (110) comporte un noyau de ferrite ou un tore fendu enroulé.

15. Ensemble selon la revendication 14, **caractérisé en ce, que** les dimensions du noyau du transformateur d'impulsions (110) présentent une section de 10 $cm^2$ environ.

**16.** Ensemble selon l'une des revendications 8 à 15, **caractérisé en ce, que**, sur le transformateur d'impulsions (110), les enroulements soient réalisés sur le noyau avec un fil à isolation haute tension.

**17.** Ensemble selon l'une des revendications 8 à 16, **caractérisé en ce, que**, sur le transformateur d'impulsions (110), les enroulements soient réalisés sur un corps d'enroulement isolant ou sur des corps d'enroulements séparés.

**18.** Ensemble selon l'une des revendications 9 à 17, **caractérisé en ce, qu'**une atmosphère gazeuse isolante ou un fluide isolant soit disponible pour l'isolation.

**19.** Ensemble selon l'une des revendications 16 à 18, **caractérisé en ce, que**, sur le transformateur d'impulsions (110), un scellement soit présent, ledit scellement étant réalisé avec des matériaux appropriés, en particulier avec des résines ou d'autres polymères.

**20.** Ensemble selon l'une des revendications 9 à 19, **caractérisé en ce, qu'**il comporte côté primaire un circuit pour la production d'impulsions de haute tension, ledit circuit comportant un condensateur (104) pouvant être chargé par une tension prédéfinie et un commutateur à semi-conducteurs (105) à fermeture dans l'enroulement primaire (111) du transformateur d'impulsions (110).

# FIG 1
( Stand der Technik )

# FIG 2

FIG 3

R_CH 200

Cp 0.2uF

Ls 500μH

A*

L_CH 1mH
103

104

106

107

108

Cs 0.2nF

S
115

T1 1:15

102 + 4000V

101

110

111

112

105

FIG 4

R_CH 4

L11

L21

L31

L_CH 3

S1

S2

S3

C1

C2

C3

1

A*

2 + UI

L12

L22

L32

30

5

10

20

C_K

100

T

109

110

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2004100371 A1

**In der Beschreibung aufgeführte Nicht-Patentliteratur**

- **SCHULTHEISS et al.** INDUSTRIAL-SCALE ELECTROPORATION OF PLANT MATERIAL USING HIGH REPETITION RATE MARX GENERATORS. *Proceedings IEEE Pulsed Power Conference,* 2002
- OPERATION OF 20 HZ MARX GENERATORS ON A COMMON ELECTROLYTIC LOAD IN AN ELECTROPORATION CHAMBER. *Proceedings IEEE Power Modulator Symposium,* 2003
- All-Solid-State Marx Modulator with Digital Pulse-Shape Synthesis. **KIRBIE et al.** Bericht Nr. LA-UR-05-0631. Los Alamos National Laboratory, 2005
- **SCHULTHEISS et al.** Wear-less Trigger Method for Marx Generators in Repetitive Operation. *Proceedings IEEE Power Modulator Symposium,* 2003